Europäisches Patentamt

European Patent Office

Office européen des brevets

(19)

(11) Numéro de publication: **0 022 700**
**A1**

(12) **DEMANDE DE BREVET EUROPEEN**

(21) Numéro de dépôt: **80400969.4**

(51) Int. Cl.³: **H 03 H 2/00**

(22) Date de dépôt: **27.06.80**

(30) Priorité: **06.07.79 FR 7917602**

(43) Date de publication de la demande: **21.01.81**
**Bulletin 81/3**

(84) Etats contractants désignés: **DE GB IT NL SE**

(71) Demandeur: **"THOMSON-CSF", 173, Boulevard Haussmann, F-75360 Paris Cedex 08 (FR)**

(72) Inventeur: **Castera, Jean-Paul, "THOMSON-CSF" SCPI 173, Bld Haussmann, F-75360 Paris Cedex 08 (FR)**
Inventeur: **Hartemann, Pierre, "THOMSON-CSF" SCPI 173, Bld Haussmann, F-75360 Paris Cedex 08 (FR)**
Inventeur: **Dupont, Jean-Marie, "THOMSON-CSF" SCPI 173, Bld Haussmann, F-75360 Paris Cedex 08 (FR)**

(74) Mandataire: **Wang, Pierre et al, "THOMSON-CSF" - SCPI 173, bld. Haussmann, F-75360 Paris Cedex 08 (FR)**

(54) **Dispositif à ondes magnétostatiques comportant une structure d'échange à bandes conductrices.**

(57) Une couche ferrimagnétique (2) porte une structure d'échange (c) constituée par un faisceau de bandes conductrices (7) ayant leurs extrémités réunies par des arêtes conductrices (6). Réalisation de dispositifs à ondes magnétostatiques utilisant des coupleurs, des jonctions hybrides, des miroirs de renvoi, des structures de prélèvement et des résonateurs.

# DISPOSITIF A ONDES MAGNETOSTATIQUES COMPORTANT UNE STRUCTURE D'ECHANGE A BANDES CONDUCTRICES.

La présente invention se rapporte aux dispositifs microondes utilisant la propagation d'ondes magnétostatiques dans un milieu ferrimagnétique. En partant d'un substrat constitué par exemple par un grenat de gadolinium et gallium (GGG) orienté $\langle 111 \rangle$ , on peut faire croître par épitaxie une couche ferrimagnétique mince de grenat d'yttrium et de fer (YIG). Cette couche ferrimagnétique dont l'épaisseur peut varier entre quelques microns et quelques dizaines de microns est capable de propager différents types d'ondes magnétostatiques avec des pertes relativement faibles . Selon l'orientation donnée à un champ magnétique de polarisation, on peut propager des ondes magnétostatiques de surface ou de volume. Les vitesses de propagation sont sensiblement plus élevées que celles que l'on rencontre dans les dispositifs à ondes élastiques de surface, ce qui facilite la réalisation de dispositifs fonctionnant à des fréquences égales ou supérieures au gigahertz. En outre, la vitesse de propagation des ondes magnétostatiques varie avec l'intensité du champ magnétique de polarisation, ce qui permet de réaliser des dispositifs accordables dans le domaine des filtres et des résonateurs. Cette propriété intéressante permet également le réglage des caractéristiques d'une ligne à retard dispersive ou non dispersive.

Dans le domaine des dispositifs à ondes élastiques de surface, on connaît des structures d'échange constituées de bandes conductrices isolées les unes des autres. Ces structures sont formées par photogravure à la surface d'un substrat piézoélectrique. Elles agissent sur la répartition de l'énergie ultrasonore de manière à réaliser une distribution, un transfert total, une concentration ou un renvoi de cette énergie.

Dans le domaine des dispositifs à ondes magnétostatiques, on connaît déjà des structures de transducteurs, des réseaux réflecteurs sélectifs composés de bandes conductrices isolées et divers moyens d'absorption. Cependant par la mise en oeuvre de structures d'échange, on peut élargir sensiblement le champ d'application des ondes magnétostatiques. Comme le mode de fabrication de tels moyens d'échange peut être le même que celui des transducteurs et des réseaux réfléchissants, les configurations qui les comprennent sont aisément réalisables par photogravure d'un film métallique déposé ou simplement appliqué contre l'une des faces de la lamelle ferrimagnétique mince selon laquelle se propagent les ondes magnétostatiques.

L'invention a pour objet un dispositif à ondes magnétostatiques comportant une couche de matériau ferrimagnétique soumise à un champ magnétique de polarisation et munie sur l'une de ses faces d'au moins une structure comportant un faisceau de bandes conductrices adjacentes, caractérisé en ce que les extrémités de ces bandes sont réunies électriquement ; la disposition de ces bandes étant telle qu'elles épousent la forme des fronts d'ondes incidents sur une partie au moins de leur longueur.

L'invention sera mieux comprise au moyen de la description ci-après et des figures annexées parmi lesquelles :

- la figure 1 est une vue isométrique d'un dispositif à ondes magnétostatiques équipé d'une structure d'échange selon l'invention ;

- la figure 2 représente en (a) et (b) la décomposition en modes symétrique et asymétrique d'un front d'onde parcourant la structure d'échange de la figure 1.

- la figure 3 illustre le comportement d'une structure d'échange à deux voies du double point de vue de la répartition des amplitudes et des relations de phase qui s'établissent le long de cette structure ;

- la figure 4 est un diagramme expérimental donnant les pertes d'insertion en fonction de la longueur d'une structure d'échange ;

- la figure 5 représente une structure d'échange établissant un couplage entre deux dispositifs à ondes magnétostatiques ;

- la figure 6 représente une variante de réalisation de la structure d'échange de la figure 5 ;

- la figure 7 représente une autre variante de réalisation de la structure d'échange de la figure 6 ;

- la figure 8 représente un dispositif à ondes magnétostatiques comportant un transducteur à éléments multiples avec pondération d'amplitude ;

- la figure 9 représente un dispositif à ondes magnétostatiques à quatre voies formant une jonction hybride ;

- la figure 10 représente un dispositif à ondes magnétostatiques permettant de comprimer en largeur un front d'onde ;

- la figure 11 représente un dispositif à ondes magnétostatiques permettant de changer la direction de propagation d'un front d'onde ;

- les figures 12 et 13 représentent des dispositifs à ondes magnétostatiques utilisant une structure d'échange en U ;

- les figures 14 et 15 représentent des dispositifs à ondes magnétostatiques utilisant une structure d'échange en J ;

-la figure 16 représente un dispositif à ondes magnétostatiques comportant un réflecteur composite ;

- la figure 17 représente un dispositif à ondes magnétostatiques comprenant deux résonateurs couplés.

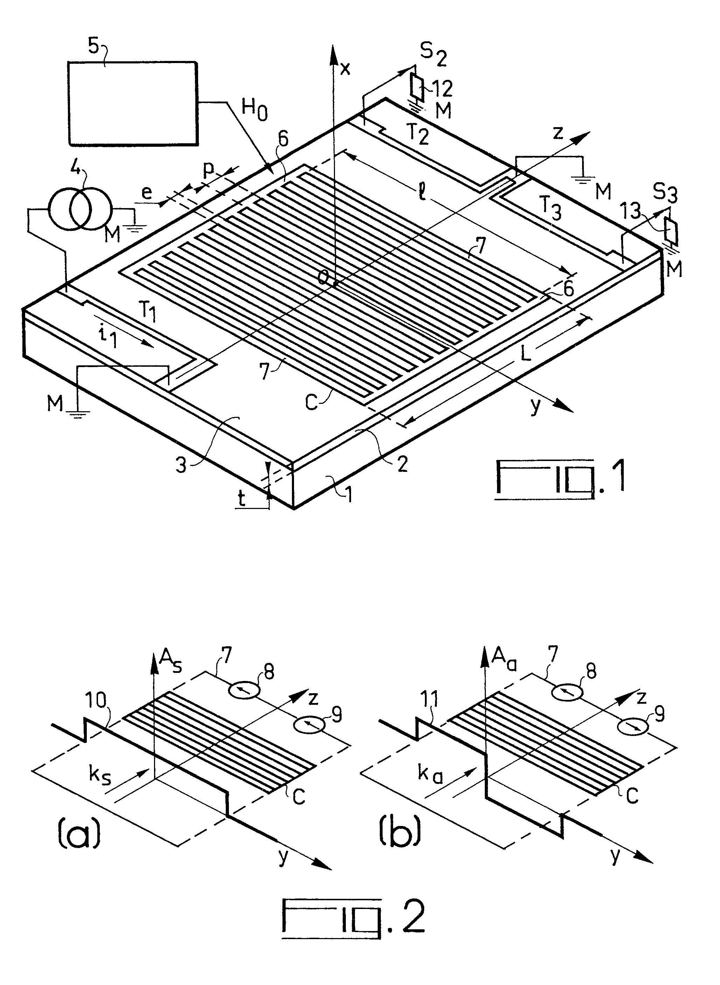

Sur la figure 1, on peut voir une vue isométrique d'un dispositif à ondes magnétostatiques comprenant par exemple un substrat 1 en grenat de gadolinium et gallium (GGG) à la surface duquel on a fait croître par épitaxie une couche ferrimagnétique mince 2 de grenat d'yttrium et de fer (YIG) dont l'épaisseur t est de 20 microns. La surface 3 de la couche ferrimagnétique 2 est confondue avec le plan yoz du système d'axes de référence Oxy. Cette couche 2 est soumise à un champ magnétique $\vec{Ho}$ produit par un inducteur 5. Selon l'orientation du champ $\vec{Ho}$, on peut distinguer trois sortes d'ondes magnétostatiques.

Lorsque le champ magnétique $\vec{Ho}$ est perpendiculaire à la surface 3, c'est-à-dire parallèle à l'axe ox, la couche propage des ondes magnétostatiques de volume dites progressives.

Lorsque le champ magnétique $\vec{Ho}$ est orienté selon l'axe oz, la couche propage des ondes magnétostatiques de volume dites régressives.

Enfin, lorsque le champ magnétique $\vec{Ho}$ est orienté parallèlement à l'axe oy la couche propage des ondes magnétostatiques de surface dites progressives ; ces ondes étant non réciproques, la propagation a lieu dans la direction du produit vectoriel $\vec{Ho} \times \vec{n}$ où $\vec{n}$ est la normale à la surface dirigée vers l'extérieur.

Dans la suite de la description, n'importe lequel des types d'ondes peut être envisagé.

Dans le cas de la figure 1, on peut par exemple supposer que l'on est en présence d'ondes magnétostatiques de surface émises par un transducteur $T_1$ et qui se propagent dans la direction oz lorsque le champ $\vec{Ho}$ est orienté en sens contraire de l'axe oy. Le transducteur

$T_1$ comporte un élément conducteur rectiligne parcouru par un courant $i_1$ parallèle à l'axe oy. Ce courant d'excitation $i_1$ est délivré par un générateur micro-onde 4 branché aux extrémités du transducteur $T_1$.

Des transducteurs $T_2$ et $T_3$ sont agencés à l'opposé de la couche 2, afin de convertir les ondes magnétostatiques incidentes en signaux électriques $S_2$ et $S_3$ qui se manifestent aux bornes des impédances de charge 12 et 13. Les transducteurs $T_1$ et $T_2$ sont agencés face à face de telle manière que les ondes magnétostatiques puissent être directement échangées en l'absence de tout autre moyen. Le transducteur $T_3$ est décalé de façon à recueillir les ondes magnétostatiques dont la trajectoire a été modifiée par l'insertion du dispositif d'échange C.

Le dispositif d'échange C est constitué par un faisceau de bandes conductrices 7 formant à la surface 3 de la couche ferrimagnétique 2 une nappe de conducteurs alignés selon les fronts d'ondes provenant du transducteur $T_1$. Cette nappe de conducteurs a une largeur l voisine du double de la largeur du transducteur $T_1$. La nappe présente une longueur L dans le sens de la propagation des ondes magnétostatiques. A chaque bord latéral de la nappe, les conducteurs 7 sont interconnectés par des bandes conductrices 6. La largeur des conducteurs 7 est égale à e tandis que leur pas est égale à p. Il y a lieu de noter que le pas p est choisi de façon à ne pas correspondre à un multiple de la demi-longueur d'onde tel que les réflexions élémentaires produites par les bandes conductrices 7 puissent être en concordance de phase. En effet, le faisceau de bandes 7 ne doit en aucune façon former un réseau réflecteur. L'existence des bandes conductrices implique aussi que e soit inférieur à p, puisque conformément à l'invention, on s'arrange pour canaliser les courants induits dans la nappe, ce qui ne serait pas le cas si celle-ci étant constituée par une couche conductrice recouvrant complètement la surface 3 dans une plage rectangulaire de dimensions 1 X L.

Dans le cas de la figure 1, l'excitation du dispositif d'échange C par les ondes magnétostatiques engendrées par le transducteur $T_1$ est caractérisée par un front d'onde incident parallèle à oy le long duquel la distribution des amplitudes prend la forme d'une fonction rectangulaire ayant une valeur unitaire pour les points de coordonnée $y < 0$ et une valeur nulle pour les points de coordonnée $y > 0$. Cette distribution peut être considérée comme la somme algébrique de deux distributions d'amplitudes correspondant à des modes d'excitation symétrique et asymétrique qui peuvent traverser la structure d'échange C avec des vitesses de phase différentes.

Sur la figure 2, on a représenté en (a) l'excitation de la structure d'échange C par une onde magnétostatique ayant $k_s$ pour nombre d'onde et caractérisée par une distribution 10 d'amplitudes $A_s$ uniforme d'un bord à l'autre de la structure d'échange. Une telle onde se propage selon un mode symétrique tel que les forces électromotrices 8 et 9 induites dans les deux moitiés d'une bande conductrice 7 s'ajoutent. Il en résulte un courant induit circulant le long d'une boucle constituée par chaque bande conductrice 7 et par l'ensemble de ses voisines. Bien entendu, le courant induit peut également se refermer par un conducteur de masse qui entoure le support de la structure d'échange. Dans ce cas toutes les extrémités des bandes sont interconnectées par ce conducteur de masse. Ce conducteur de masse sera avantageusement constitué par un dépôt métallique enveloppant. Les conditions aux limites imposées à l'interface 3 par la présence des courants induits orientés selon les bandes de la structure d'échange C se traduisent par des propriétés de propagation qui paraissent peu différentes de celle que l'on rencontre dans les plages non couvertes de la surface 1. Physiquement tout semble se passer comme si le mode symétrique ne "voyait" pas les bandes conductrices 7. Quoi qu'il en soit, l'écart entre $k_s$ et $k_s$ s'avère sensiblement égal à l'écart entre les nombres d'ondes correspondant respectivement à une couche ferrimagnétique nue et à une couche ferrimagnétique recouverte complètement de métal.

La figure 2 montre en (b) l'excitation de la même structure d'échange C par une onde magnétostatique ayant $k_a$ pour nombre d'onde et caractérisée par une distribution 11 d'amplitudes $A_a$ dont le signe s'inverse au point de coordonnée y = O. Le mode de propagation asymétrique associé à cette distribution tend à induire dans les deux moitiés de chaque bande conductrice 7 des forces électromotrices 8 et 9 égales et de signes contraires. Il en résulte qu'aucun courant induit ne circule selon les bandes conductrices 7 de sorte que la structure influence la propagation comme le ferait une couche conductrice continue. Les conditions aux limites s'appliquant à ce type de situation se traduisent par des propriétés de propagation assez différentes de celles que l'on rencontre dans les plages non couvertes de la surface 3.

D'après ce qui précède, on voit que les modes symétriques et asymétriques se propagent suivant l'axe z avec des vitesses de phase distinctes. Les nombres d'ondes $k_s$ et $k_a$ sont différents l'un de l'autre, ce qui donne naissance à des phénomènes d'interférence entre les deux modes propagés. Ces phénomènes d'interférence peuvent se mettre sous la forme d'une propagation ayant pour nombre d'onde

$$k = \frac{k_a + k_s}{2}$$ moyennant l'introduction d'un déphasage différentiel entre les ondes propagées de part et d'autre de l'axe z. Ce déphasage différentiel $\Delta\phi$ s'exprime par la relation :

$$\Delta\phi = 2 \, L.K$$

où K est une constante de couplage dont la valeur est donnée par :

$$K = \frac{k_a - k_s}{2}$$

L est la distance parcourue dans la direction de l'axe z.

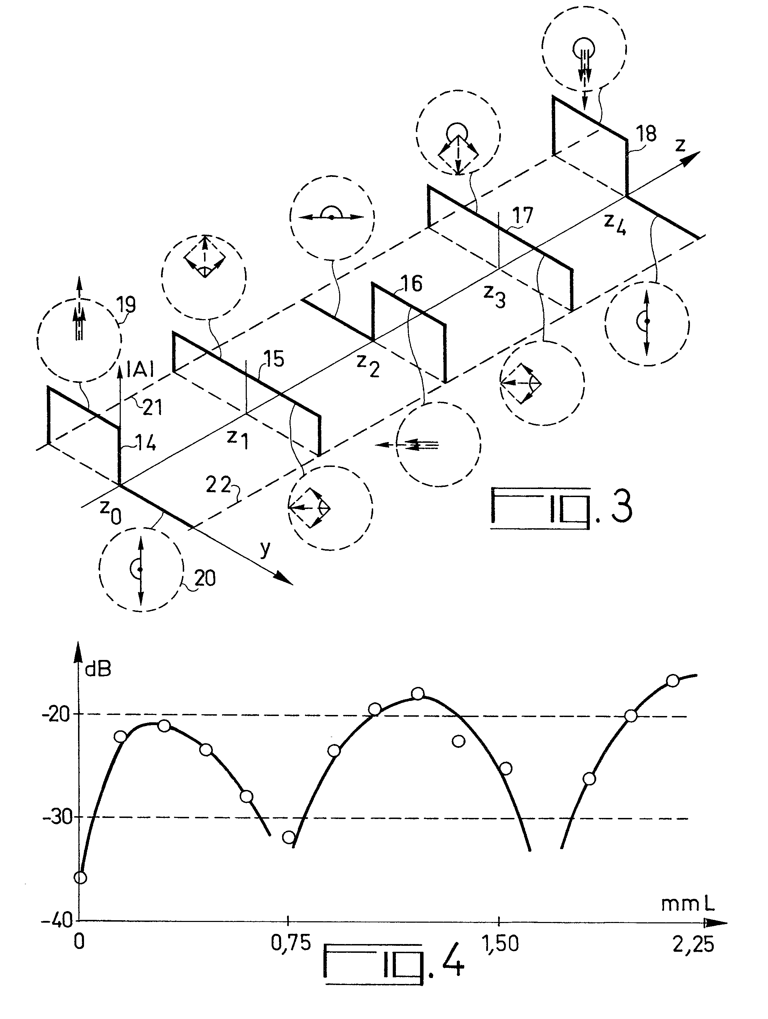

Sur la figure 3, on a représenté les changements que subit la répartition des amplitudes dans un front d'onde qui se propage suivant z au travers de la structure d'échange C. La distribution d'amplitudes incidente 14 correspond par exemple à un front d'onde situé à l'abscisse $y_0$. On voit que le module $|A|$ de l'amplitude a une valeur constante dans l'étendue de la voie de transmission comprise entre l'axe z et la ligne pointillée 21. Par contre, le module $|A|$ a une valeur nulle dans l'étendue de la voie de transmission comprise entre l'axe z et la ligne pointillée 22.

Pour illustrer les relations de phase le long du front d'onde, on a représenté sur la figure 3 par des vecteurs en traits pleins les composantes symétriques et asymétrique ayant pour somme la distribution 14 ; la somme vectorielle est représentée par un vecteur en pointillé. Les relations de phase sont entourées d'un cercle en pointillé référencé 19 lorsqu'il s'agit de la voie de transmission comprise entre l'axe z et la ligne 21 et référencé 20 lorsqu'il s'agit de la voie de transmission comprise entre l'axe z et la ligne 22.

L'examen de la figure 3 montre que l'énergie des ondes magnétostatiques incidentes se distribue sur les deux voies après avoir parcouru la distance $z_0 z_1$. A l'abscisse $z_1$ on obtient une distribution d'amplitude uniforme 15, mais les deux voies délivrent des amplitudes en quadrature de phase. Après un parcours supplémentaire $z_1z_2$ toute l'énergie des ondes magnétostatiques se répartit comme l'indique la distribution 16, c'est-à-dire qu'elle est passée complètement de la voie gauche dans la voie droite. Un autre parcours $z_2z_3$ égalise à nouveau la répartition de l'énergie entre les deux voies avec des résultats également en quadrature de phase ,mais dans le sens inverse. C'est ce que montre la distribution 17 et les relations de phase associées. Un dernier trajet $z_3z_4$ ramène toute l'énergie dans la voie gauche comme le montre la distribution d'amplitude 18. On peut montrer que le transfert total de l'énergie se produit pour une longueur de structure d'échange égale à :

$$L_0 = \frac{\Pi}{2K}$$

Une telle structure d'échange constitue un coupleur total.

Une structure d'échange ayant une longueur égale à $nL_{0/2}$ se comporte comme un coupleur à 3 dB si n est un nombre impair.

Une structure d'échange ayant une longueur égale à $m\ L_0$ ne provoque aucun transfert d'énergie entre les deux voies lorsque m est un nombre pair. Dans ce cas, il y a isomorphisme entre la distribution d'amplitudes du front d'onde incident et du front d'onde émergent La distance $L_i$ la plus faible donnant lieu à cet isomorphisme est égale à deux fois $L_0$.

D'une façon générale, une longueur L quelconque redistribue les amplitudes dans un rapport quelconque avec un déphasage entre voies de $\pm$ 90°.

A titre d'exemple non limitatif, en adoptant la configuration de la figure 1, on a réalisé un dispositif expérimental ayant les caractéristiques suivantes:

Structure d'échange C :

Largeur des bandes métalliques : e = 75 microns

10

Distance entre bandes métalliques : p - e = 75 microns

Longueur des bandes métalliques : l = 9 mm

Nombre de bandes métalliques : 20

Transducteurs $T_1$, $T_2$, $T_3$ : largeur : 30 microns longueur : 4 mm.

Couche ferrimagnétique :

épaisseur : t = 20 microns, matériau YIG

champ magnétique appliqué : $H_o$ = 288 Oersteds

moment magnétique à saturation :

$4 \pi M$ = 1750 Oersteds.

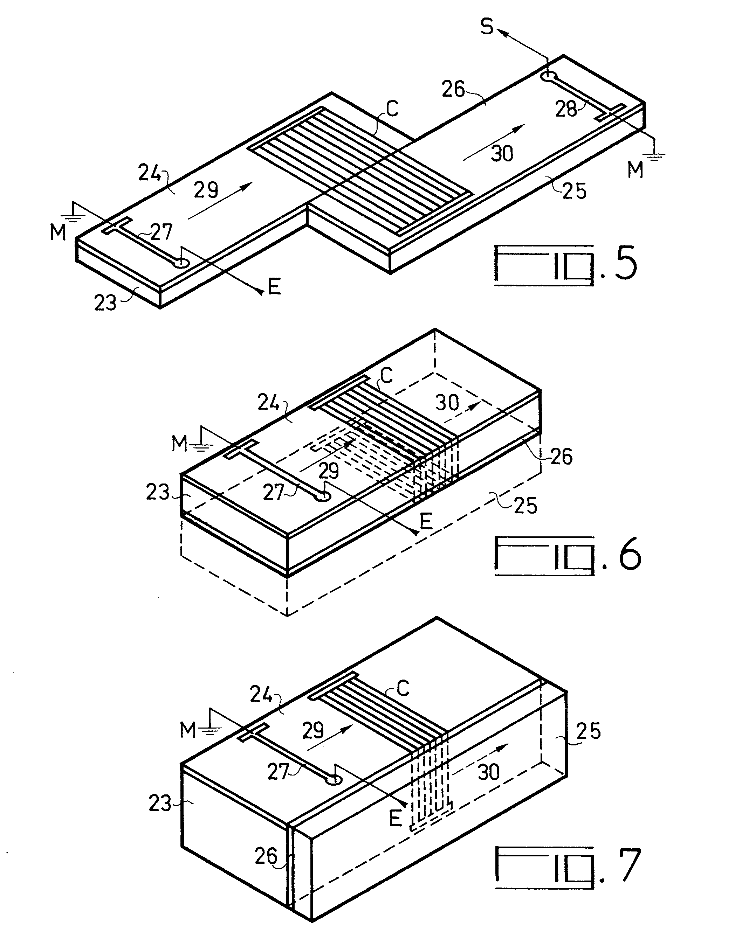

Le diagramme de la figure 4 a été relevé entre le transducteur $T_1$ et le transducteur $T_3$. Il donne à la fréquence f de 2,45 GHz les pertes d'insertion en décibels en fonction de la longueur L de la structure d'échange. Les arches en traits pleins illustrent les transferts d'énergie observés ; des cercles représentent les points de mesure . La variation de longueur a été obtenue en supprimant des bandes par attaque chimique.

Le tableau suivant donne quelques indications pratiques et théoriques sur le fonctionnement de la structure d'échange décrite ci-dessus :

| f (GHz) | $L_o$ ($\mu$m) | K (expérimental) ($\mathrm{mm}^{-1}$) | K théorique ($\mathrm{mm}^{-1}$) |
|---|---|---|---|
| 2,45 | 487 | 3,22 | 2,41 |
| 2,50 | 427 | 3,70 | 2,94 |
| 2,55 | 375 | 4,19 | 3,53 |
| 2,60 | 337 | 4,65 | 4,17 |
| 2,65 | 337 | 4,65 | 4,88 |
| 2,70 | 319 | 4,93 | 5,68 |
| 2,75 | 300 | 5,24 | 6,00 |
| 2,80 | 262 | 5,98 | 7,60 |

La structure d'échange à bandes conductrices court-circuitées telle qu'elle vient d'être décrite trouve de multiples applications. La plus simple consiste à réaliser un couplage entre deux transducteurs situés sur deux voies contigues. En omettant sur la figure 1 le transducteur $T_2$, on voit que l'ensemble se comporte comme une ligne à retard ou un filtre bénéficiant d'un couplage à large bande. Dans cette réalisation, on choisit une longueur L égale à $L_0$ de façon à obtenir un couplage à 100 %. On peut remarquer que le coupleur à bande peut être constitué par un dépôt métallique effectué sur la surface 3 et délimité par photogravure, mais on peut également faire ce dépôt par exemple sur une plaque d'alumine et poser la face gravée de cette plaque contre la surface 3.

Sur la figure 5, on peut voir deux dispositifs à ondes magnétostatiques interconnectés au moyen d'un coupleur total C. Les substrats 23 et 25 sont revêtus de couches ferrimagnétiques 24 et 26 équipées respectivement d'un transducteur d'émission 27 émettant des ondes magnétostatiques dans la direction 29 et d'un transducteur de réception 28 recevant les ondes magnétostatiques transmises dans la direction 30. Les surfaces des deux couches 24 et 26 sont coplanaires et contigues dans la région du coupleur C. De ce fait, l'énergie électromagnétique circule de l'entrée E à la sortie S via le coupleur C.

Sur la figure 6, on a représenté un dispositif à ondes magnétostatiques comportant un substrat 23 muni sur ses deux faces de couches ferrimagnétiques 24 et 26. Le transducteur 27 émet des ondes magnétostatiques dans la direction 29. Le coupleur C est ici une structure en U qui contourne le substrat afin de transmettre les ondes magnétostatiques sur l'autre face où elles se propagent dans la direction 30. Une modification du dispositif à ondes magnétostatiques double face est représentée en pointillé sur la figure 6. Elle consiste à utiliser pour porter la couche ferrimagnétique 26 un autre substrat 25. Dans ce cas, la moitié inférieure du coupleur C repose directement sur la face inférieure du substrat 23 et les deux dispositifs sont empilés pour que le coupleur C couple effectivement les surfaces des couches 24 et 26.

Sur la figure 7, on peut voir une disposition dans laquelle les couches ferrimagnétiques 24 et 26 sont portées par des substrats 23 et 25 assemblés de façon que les surfaces des couches forment un dièdre. Avec une telle configuration, les deux moitiés du coupleur C s'étendent sur deux faces de l'un des dispositifs formant un dièdre. On pourrait bien entendu faire porter les deux couches 24 et 26 par le même substrat 23 et faire en sorte que le coupleur C recouvre les deux couches moitié par moitié.

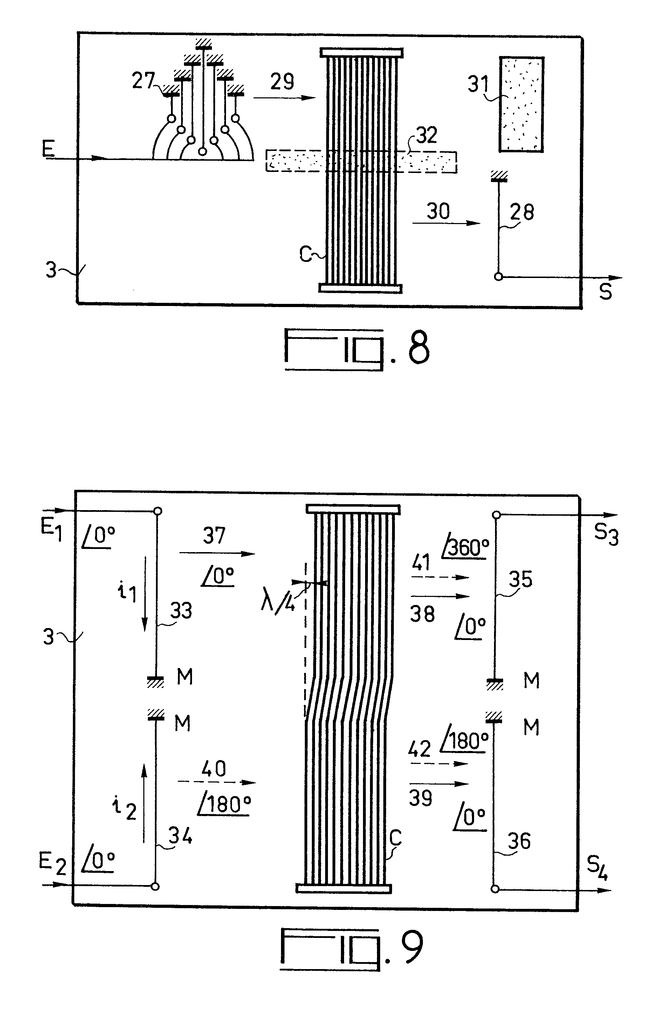

Sur la figure 8, on peut voir une autre utilisation d'un coupleur total C. Il s'agit d'uniformiser les fronts d'ondes rayonnés par un transducteur 27 composé de plusieurs éléments ayant des longueurs inégales. Les ondes transmises dans la direction 30 présentent un front d'onde redressé compatible avec la forme rectiligne du transducteur récepteur 28. Le résidu d'énergie qui n'est pas transféré par le coupleur C peut être absorbé par la zone sablée 31. Une autre zone sablée 32 formée sous le coupleur C permet d'empêcher le rayonné direct entre le transducteur 27 et le transducteur 28.

Jusqu'ici, les bandes conductrices du coupleur C étaient rectilignes d'un bout à l'autre en laissant de côté les pliages illustrés par les figures 6 et 7.

On peut également envisager des structures d'échange dont les bandes conductrices sont formées de portions rectilignes qui ne sont pas dans le prolongement l'une de l'autre.

Sur la figure 9 on peut voir une jonction hybride encore connue sous le vocable "Té magique" qui comprend quatre transducteurs 33, 34, 38 et 39 alignés deux à deux à la surface 3 d'une couche ferrimagnétique. La jonction hybride possède deux voies d'entrée $E_1$ et $E_2$ reliées respectivement aux transducteurs 33 et 34. Elle comporte également deux voies de sortie $S_3$ et $S_4$ auxquelles sont respectivement branchés les transducteurs 35 et 36. Entre les transducteurs d'entrée et de sortie on a intercalé une structure d'échange C dont les bandes présentent au milieu un décrochement d'amplitude $\lambda/4$, où $\lambda$ est la longueur d'onde de fonctionnement de la jonction hybride (il s'agit de la longueur d'onde calculée à partir des propriétés de la couche ferrimagnétique).

Si l'on suppose que la longueur de la structure d'échange C est égale à la moitié de la longueur $L_o$, celle-ci fonctionne à la manière d'un coupleur 3 dB qui distribue en deux parties égales l'énergie électromagnétique incidente sur l'une de ses moitiés ; de plus, on sait que les amplitudes transmises dans les deux voies de sortie sont en quadrature de phase.

Sur la figure 9, on a supposé que les voies d'entrée $E_1$ et $E_2$ reçoivent des signaux de mêmes amplitudes et ayant tous deux un déphasage nul par rapport à une référence de phase appropriée. Ces signaux font circuler des courants $i_1$ et $i_2$ qui provoquent l'émission d'ondes magnétostatiques 37 et 40 qui ont des amplitudes égales et dont les déphasages sont respectivement $\lfloor 0°$ et $\lfloor 180°$. L'inversion de phase est due au fait que les masses M des transducteurs 33 et 34 sont en positions intérieures. L'onde 37 est distribuée par le coupleur C à raison d'une composante 38 de déphasage nul et d'une composante 39 déphasée de $\lfloor 0°$. Ce dernier déphasage nul résulte de l'avance de phase de 90° introduite par le coupleur C et du retard de phase de 90° créé par le décrochement de λ/4.

L'onde 40 est distribuée par le coupleur C à raison d'une composante 42 de déphasage $\lfloor$180° et d'une composante 41 déphasée de $\lfloor$360°. Ce dernier déphasage résulte d'une avance de phase de 90° introduite par le coupleur C et d'une autre avance de phase créée par le décrochement de λ/4. Dans ces conditions, on voit que toute l'énergie est couplée dans la voie $S_3$.

Par contre, si les signaux entrants sont en opposition de phase, on peut montrer que toute l'énergie est couplée dans la voix $S_4$.

Il s'agit bien d'une jonction hybride constituée essentiellement par le coupleur 3 dB avec décrochement en λ/4.

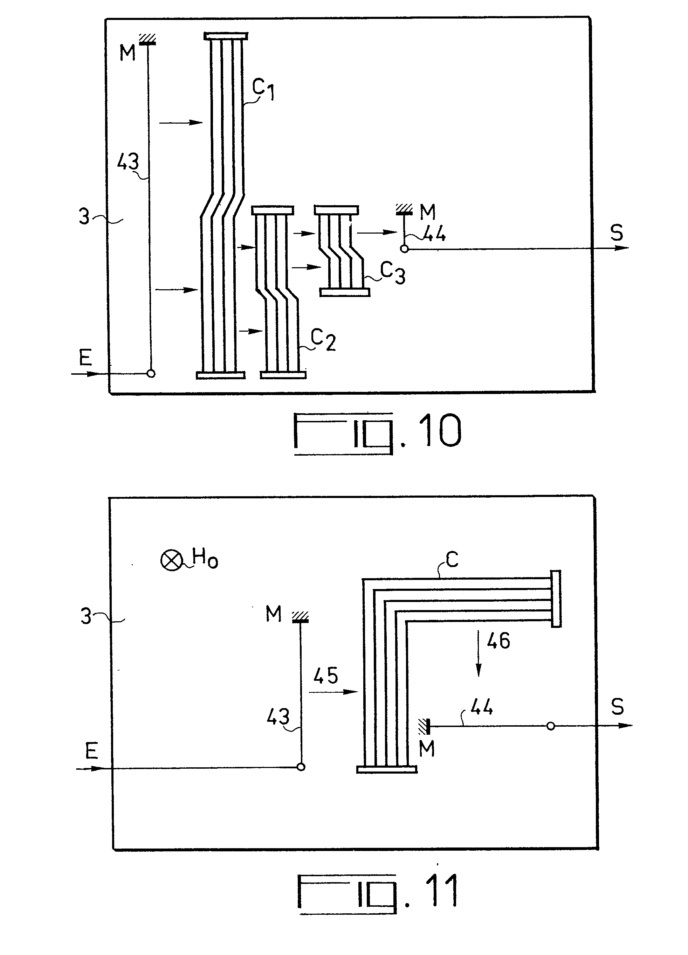

Sur la figure 10, on peut voir un dispositif à ondes magnétostatiques permettant de concentrer l'énergie électromagnétique fournie par un transducteur d'émission de grande longueur 43. Trois jonctions hybrides $C_1$, $C_2$ et $C_3$ sont disposées en cascade pour réaliser une concentration égale à $2^3$. La largeur totale des jonctions varie comme les nombres 4, 2 et 1. Cet agencement permet de convertir un front d'onde incident de largeur 1 en un front d'onde de largeur 1/8 avec un relèvement de niveau de puissance approchant 9 dB.

Dans ce qui précède, la décomposition de la distribution d'amplitudes en modes symétrique et asymétrique est basée sur une excitation incidente occupant la moitié de la largeur 1 de la structure d'échange. Cette condition n'est pas limitative, car on peut également supposer que l'excitation s'étende sur une partie plus importante de la largeur 1. Dans ce cas, une concentration importante des ondes magnétostatiques incidentes peut être réalisée en une seule fois grâce à une seule jonction hybride dont on a ajusté la valeur du décrochement pour que les ondes émergentes ne puissent s'ajouter que dans la voie la plus étroite.

Sur la figure 11, on peut voir un dispositif à ondes magnétostatiques permettant de réaliser un changement de la direction de propagation. Dans le cas où le champ magnétique inducteur $\vec{H}_o$ est orienté perpendiculairement à la surface 3 de la couche ferrimagnétique, on sait que celle-ci peut propager suivant des directions distinctes des ondes magnétostatiques de volume dites progressives. De telles ondes sont émises par le transducteur 43 et sont rayonnées dans la direction 45. Pour qu'elles puissent être reçues par le transducteur récepteur 44; la figure 11 prévoit une structure d'échange C présentant dans la surface 3 de la couche ferrimagnétique un tournant à 90° des bandes conductrices. Ainsi les ondes émergentes peuvent prendre la direction 46, qui est orthogonale à la direction 45. Bien entendu, l'angle peut prendre toute valeur désirée. Cette structure peut être réalisée sous la forme d'un coupleur total de longueur $L_o$, mais il est également possible de choisir une longueur différente pour distribuer les ondes incidentes selon deux directions distinctes.

Sur la figure 12, on peut voir un dispositif à ondes magnétostatiques dans lequel la structure d'échange C comporte deux coudes successifs à angle droit. Cette structure se présente sous la forme d'un U à branches parallèles fonctionnant en miroir à large bande lorsqu'on adopte une longueur $L_{o/2}$ qui partage l'onde incidente en deux fractions égales en quadrature de phase. Le transducteur d'émission 43 est normalement à rayonnement bilatéral, mais en association avec la structure réfléchissante C, il forme un ensemble à rayonnement unilatéral. Pour comprendre le fonctionnement en miroir, il faut considérer la bande conductrice extérieure 48 qui reçoit en provenance du transducteur 43 une onde incidente dont l'amplitude A présente un déphasage nul par rapport à la référence de phase. La bande intérieure 47 de la structure en U rayonne vers la droite à l'intérieur du U une onde d'amplitude 0,7 A ayant un déphasage nul et vers la gauche une onde d'amplitude 0,7 A ayant un déphasage $\lfloor$90°. La structure en U subdivise à nouveau les deux ondes qui circulent entre ses branches en deux ondes qui émergent vers la droite de la bande extérieure 48 avec des amplitudes 0,5 A et des déphasages $\lfloor$0° et $\lfloor$180°. Ces ondes sont égales et de signes contraires, ce qui annule toute transmission vers la droite. L'onde 0,70 $\lfloor$90° qui circule entre les branches est subdivisée en deux ondes émergeant vers la gauche de la bande extérieure 48. Ces deux ondes ont des amplitudes 0,5 A et des déphasages égaux $\lfloor$90°. Ainsi l'onde incidente A est complètement réfléchie avec un déphasage de $\lfloor$90°. Etant donné que le coupleur C est par construction un dispositif à large bande, l'effet de miroir est également à large bande. .

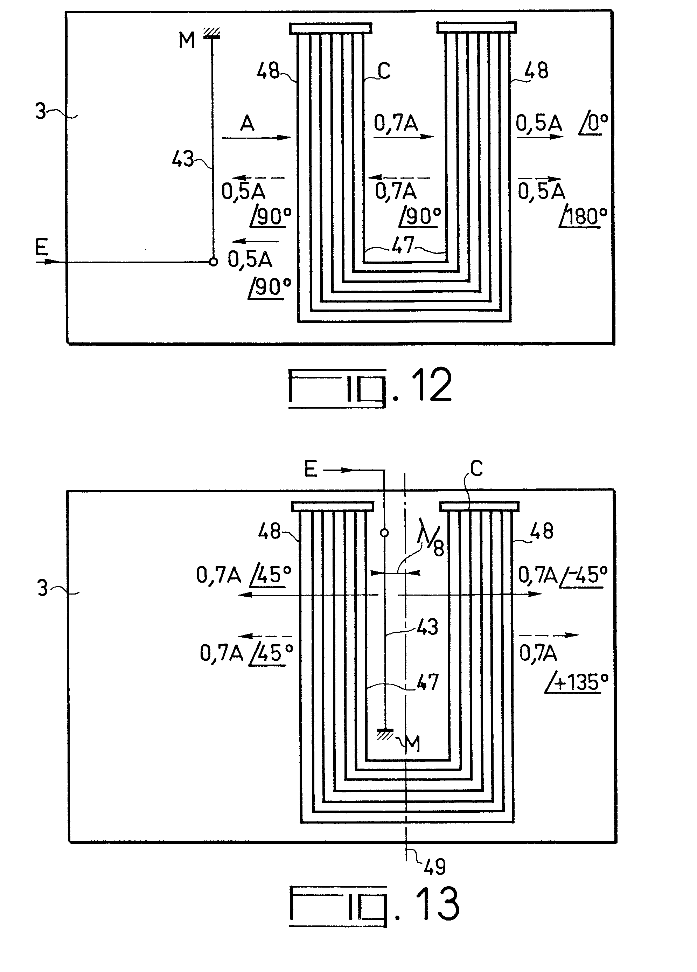

Sur la figure 13, on peut voir un dispositif à ondes magnétostatiques qui permet d'obtenir une émission ou une réception unidirectionnelle avec une bande de fréquence étroite. Dans cette variante, le transducteur 43 est situé entre les deux branches du coupleur en U. La position du transducteur 43 est décalée d'un huitième de longueur d'onde par rapport à l'axe de symétrie 49 du coupleur en U. Les ondes émises par le transducteur 43 ont des amplitudes égales à A lorsqu'elles atteignent la bande intérieure 47 du coupleur C. L'une de ces ondes présente un déphasage de $\lfloor$45°. et l'autre un déphasage de $\searrow$- 45°. La bande extérieure 48 du coupleur C rayonne vers la droite deux ondes d'amplitude 0,7 A qui ont pour déphasage $\lfloor - 45°$ et $\lfloor + 135°$. Ces ondes en opposition de phase donnent une résultante nulle. Vers la gauche, la bande extérieure 48 du coupleur C rayonne deux ondes d'amplitude 0,7 A qui ont le même déphasage $\lfloor 45°$. On obtient donc au total une onde résultante ayant une amplitude 1,4 A et par conséquent une puissance égale à la somme des puissances rayonnées à l'intérieur du coupleur C par le transducteur 43.

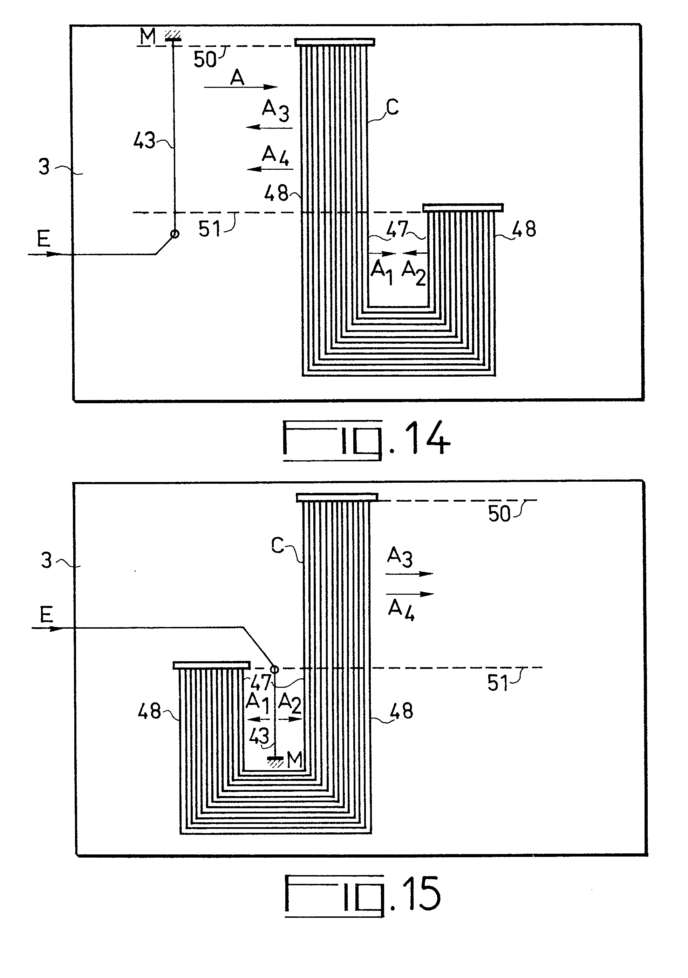

Sur la figure 14, on peut voir un dispositif à ondes magnétostatiques utilisant une structure d'échange C fonctionnant en coupleur total avec deux couches à 90° et des branches de longueurs inégales. La branche de droite du coupleur C se termine à hauteur d'une ligne en pointillé 51 tandis que la branche de gauche se termine à hauteur d'une ligne en pointillé 50. L'onde rayonnée vers la droite par le transducteur 43 possède une amplitude A. Elle est reçue par la bande extérieure 48 du coupleur C qui rayonne par sa bande intérieure 47 deux ondes $A_1$ et $A_2$ contraprogressives. Ces ondes sont à leur tour reçues par la bande intérieure 47 et réémises par la bande extérieure 48 sous la forme de deux composantes de même sens $A_3$ et $A_4$. Ce coupleur en forme de J constitue un miroir de renvoi.

Sur la figure 15, on peut voir un dispositif à ondes magnétostatiques utilisant un transducteur 43 situé entre les branches d'un coupleur C en forme de J. Le transducteur 43 est situé à égale distance des deux branches. Si le coupleur C est un coupleur total de longueur $L_o$, les ondes $A_1$ et $A_2$ rayonnées par le transducteur 43 en direction de la bande intérieure 47 du coupleur sont rayonnées entre les lignes 50 et 51 sous la forme d'ondes $A_3$ et $A_4$ qui émergent de la bande extérieure 48.

Lorsque le transducteur 43 fonctionne en récepteur, on peut réaliser un coupleur en forme de J de faible longueur, qui, placé entre les lignes 50 et 51, peut servir à prélever une petite fraction des ondes magnétostatiques se propageant entre ces lignes. Un tel couplage qu'il soit total ou partiel est du type à large bande puisque le transducteur 43 est disposé symétriquement entre les branches.

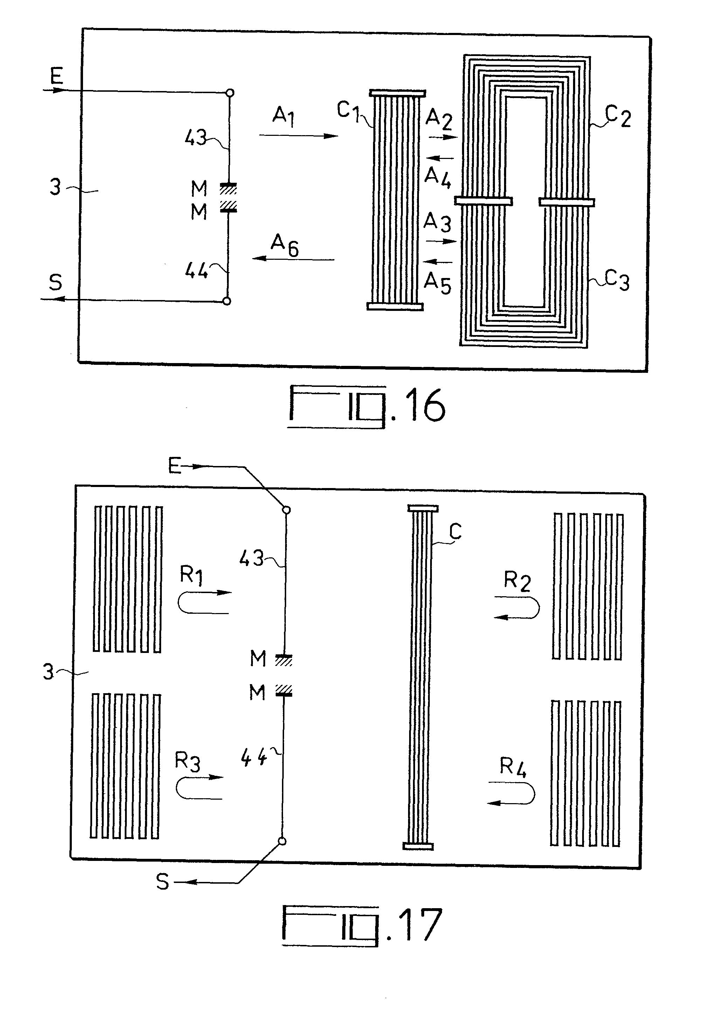

Sur la figure 16, on peut voir un dispositif à ondes magnétostatiques permettant de réaliser un changement de voie avec renvoi. Ce dispositif comporte dans la voie supérieure un transducteur d'émission 43 et dans la voie inférieure un transducteur de réception 44.

Un coupleur $C_1$ à 3 dB s'étend sur les deux voies. Deux coupleurs en U $C_2$ et $C_3$ forment dans chacune des deux voies un miroir à large bande semblable à celui de la figure 12. L'onde $A_1$ émise par le transducteur 43 est convertie par le coupleur $C_1$ en des ondes $A_2$ et $A_3$ qui à leur tour sont réfléchies sous la forme d'ondes $A_4$ et $A_5$ par les miroirs $C_2$ et $C_3$. Les ondes $A_4$ et $A_5$ reçues en retour par le coupleur $C_1$ sont converties en une onde $A_5$ qui est captée par le transducteur 44. L'échange réalisé par les coupleurs $C_1$, $C_2$ et $C_3$ est du type à large bande.

Sur la figure 17, on peut voir un dispositif à ondes magnétostatiques comprenant deux résonateurs couplés. A cet effet, la surface 3 de la couche ferrimagnétique est munie de quatre réseaux réflecteurs $R_1$, $R_2$, $R_3$ et $R_4$. Chaque réseau réflecteur est formé par exemple de bandes conductrices équidistantes dont le pas est sélectionné pour réfléchir les ondes magnétostatiques ayant une longueur d'onde prédéterminée. Le pas est donc différent de celui des bandes conductrices qui constituent le coupleur C et de plus, les bandes constituant les réseaux réflecteurs ne sont pas reliées électriquement à leurs extrémités. Les réseaux réflecteurs

$R_1$ et $R_2$ forment une première cavité de résonance qui contient le transducteur d'émission 43. Les réseaux réflecteurs $R_3$ et $R_4$ forment une seconde cavité de résonance qui renferme le transducteur de réception 44. Le coupleur C relie entre elles les deux cavités de résonance. En ajustant la longueur L du coupleur C, on peut faire varier le coefficient de couplage entre les deux cavités. Le dispositif de la figure 17 est intéressant pour réaliser un oscillateur accordable. Dans ce cas, l'entrée E et la sortie S sont branchées à la sortie et à l'entrée d'un circuit amplificateur. L'accord de l'oscillateur peut être obtenu en faisant varier le champ magnétique $H_o$ appliqué à la couche ferrimagnétique, mais cette technique d'accord n'est pas limtiée aux oscillateurs.

Dans l'exemple de réalisation de la figure 17, on voit que la surface 3 de la couche ferrimagnétique porte trois sortes d'éléments tous constitués par des bandes conductrices. Tous ces éléments peuvent être réalisés collectivement en recouvrant la surface 3 d'un dépôt métallique auquel on fait subir une attaque chimique sélective, après avoir mis en oeuvre les techniques bien connues du photomasquage.

Bien que l'on ait décrit dans ce qui précède et représenté sur les dessins, les caractéristiques essentielles de la présente invention appliquées à des modes de réalisation préférés de celle-ci, il va sans dire que l'homme de l'art peut y apporter toutes modifications de forme ou de détail qu'il juge utiles, sans pour autant sortir du cadre de ladite invention.

20

REVENDICATIONS

1. Dispositif à ondes magnétostatiques comportant une couche de matériau ferrimagnétique (2) soumise à un champ magnétique de polarisation et munie sur l'une de ses faces d'au moins une structure comportant un faisceau de bandes conductrices adjacentes (7), caractérisé en ce que les extrémités de ces bandes sont réunies électriquement ; la disposition de ces bandes étant telle qu'elles épousent la forme des fronts d'onde incidents sur une partie au moins de leur longueur.

2. Dispositif à ondes magnétostatiques selon la revendication 1, caractérisé en ce que ces bandes (7) sont rectilignes sur une partie au moins de leur longueur.

3. Dispositif à ondes magnétostatiques selon la revendication 2, caractérisé en ce que l'espacement et le pas des bandes conductrices (7) sont uniformes au moins dans cette partie rectiligne.

4. Dispositif à ondes magnétostatiques selon l'une quelconque des revendications 2 et 3, caractérisé en ce que la distance (L) séparant les bandes extrêmes du faisceau dans cette partie rectiligne est inférieure à la distance d'interaction la plus faible ($L_i$) pour laquelle une distribution d'amplitude du front d'onde incident et celle du front d'onde émergeant seraient isomorphes.

5. Dispositif à ondes magnétostatiques selon la revendication 4, caractérisé en ce que la distance (L) séparant les bandes extrêmes du faisceau est sensiblement égale à la moitié de cette distance d'interaction ($L_i$).

6. Dispositif à ondes magnétostatiques selon la revendication 4, caractérisé en ce que la distance (L) séparant les bandes extrêmes du faisceau est sensiblement égale à n fois le quart de cette distance d'interaction ($L_i$), n étant un entier impair.

7. Dispositif à ondes magnétostatiques selon l'une quelconque des revendications 1 à 6, caractérisé en ce que les bandes conductrices (C) reposent sur deux faces distinctes selon lesquelles les ondes magnétostatiques sont susceptibles de se propager.

8. Dispositif à ondes magnétostatiques selon la revendication 7, caractérisé en ce que ces faces sont contigues.

9. Dispositif à ondes magnétostatiques selon la revendication 7, caractérisé en ce que ces faces sont superposées.

10. Dispositif à ondes magnétostatiques selon l'une quelconque des revendications 1 à 6, caractérisé en ce que chacune des bandes conductrices (C) possède deux portions rectilignes reliées par un coude.

11. Dispositif à ondes magnétostatiques selon la revendication 10, caractérisé en ce que les deux portions rectilignes sont parallèles.

12. Dispositif à ondes magnétostatiques selon la revendication 10, caractérisé en ce que les deux portions rectilignes forment un angle inférieur à 180°.

13. Dispositif à ondes magnétostatiques selon la revendication 10, caractérisé en ce que les deux portions rectilignes sont égales de manière à former une structure en U.

14. Dispositif à ondes magnétostatiques selon la revendication 10, caractérisé en ce que les deux portions rectilignes sont inégales de manière à former une structure en J.

15. Dispositif à ondes magnétostatiques selon l'une quelconque des revendications 1 à 6, caractérisé en ce que chacune des bandes conductrices (C) possède deux portions rectilignes parallèles reliées par une portion oblique introduisant un décrochement de valeur prédéterminée.

16. Dispositif à ondes magnétostatiques selon la revendication 13, caractérisé en ce qu'il comprend en outre un transducteur (43) situé à l'intérieur de la structure en U ; ce transducteur étant décalé par rapport à l'axe de symétrie des branches de la structure en U.

17. Dispositif à ondes magnétostatiques selon la revendication 14, caractérisé en ce qu'il comprend en outre un transducteur (43) disposé symétriquement entre les branches de la structure en J.

18. Dispositif à ondes magnétostatiques selon la revendication 15, caractérisé en ce que les deux portions rectilignes sont égales.

19. Dispositif à ondes magnétostatiques selon la revendication 18, caractérisé en ce qu'il comprend plusieurs structures d'échange ($C_1$, $C_2$, $C_3$) agencées en cascade et chacune constituée par des bandes conductrices présentant deux portions rectilignes égales et parallèles reliées par une portion oblique présentant un décrochement de valeur prédéterminée ; les longueurs des portions rectilignes variant d'une structure d'échange à la suivante selon une progression géométrique de raison égale à deux.

20. Dispositif à ondes magnétostatiques selon la revendication 13, caractérisé en ce qu'il comprend deux structures ($C_2$, $C_3$) en U et une structure d'échange à bandes rectilignes ($C_1$) ; les branches rectilignes des structures en U étant alignées et agencées de manière à recevoir les ondes magnétostatiques provenant des bandes rectilignes de la structure d'échange.

21. Dispositif à ondes magnétostatiques selon l'une quelconque des revendications 1 à 9, caractérisé en ce qu'il comprend deux résonateurs à réseaux ($R_1$, $R_2$, $R_3$, $R_4$) ; la structure d'échange (C) pénétrant à l'intérieur de ces résonateurs, afin de réaliser un

23

0022700

couplage entre les ondes stationnaires se formant à l'intérieur des résonateurs.

22. Dispositif à ondes magnétostatiques selon l'une quelconque des revendications précédentes, caractérisé en ce que la structure d'échange (C) est associée à au moins un transducteur (27) comportant plusieurs éléments rayonnants parallèles de longueurs inégales.

23. Dispositif à ondes magnétostatiques selon l'une quelconque des revendications précédentes, caractérisé en ce que la structure d'échange est une découpe dans un film métallique placé en contact avec la couche de matériau ferrimagnétique (2).

24. Dispositif à ondes magnétostatiques selon l'une quelconque des revendications précédentes, caractérisé en ce que toutes les extrémités des bandes composant la structure d'échange sont en plus reliées entre elles par un conducteur de masse entourant l'élément (1, 2) supportant la structure d'échange.

25. Dispositif à ondes magnétostatiques selon la revendication 15, caractérisé en ce que les portions rectilignes sont de longueurs inégales.

FIG.1

FIG.2

Fig. 3

Fig. 4

Fig.5

Fig.6

Fig.7

Fig. 8

Fig. 9

$\boxed{\mathsf{F I \square}}. 10$

$\boxed{\mathsf{F I \square}}. 11$

0022700

M

48　　　　　　C　　　　48

3

43

A　→　　　　0,7A →　　　0,5A →　∠0°

0,5A ←　　　0,7A ←　　　0,5A →
∠90°　　　∠90°　　　　∠180°

E →

0,5A
∠90°

47

**Fig. 12**

E →　　　　　　C

48　　　　　　　　48

3

$\frac{\lambda}{8}$

0,7A ∠45° ←　　　　　　→ 0,7A ∠−45°

43

0,7A ∠45° ←　　　　　　→ 0,7A

47　　　　　　　∠+135°

M

49

**Fig. 13**

Fig.14

Fig.15

E →

A₁ → C₁ A₂ → C₂

43

M
M

A₄ ←

A₃ →

A₆ ← A₅ ← C₃

3

S →

44

**FIG.16**

E →

43

R₁ → C

3 R₂ ←

M
M

R₃ → 44

R₄ ←

S ←

**FIG.17**

## DOCUMENTS CONSIDERES COMME PERTINENTS

| Catégorie | Citation du document avec indication, en cas de besoin, des parties pertinentes | Revendication concernée |
|---|---|---|
| | JOURNAL OF APPLIED PHYSICS, vol. 50, no. 3, partie II, mars 1979, pages 2455-2457<br>New York, U.S.A.<br>H. WU: "Bandpass filtering and input impedance characterization for driven multielement transducer pairdelay line magnetostatic wave devices"<br><br>* Figures 1,2; page 2455, colonne de gauche, ligne 1 - page 2457, colonne de gauche, ligne 4 * | 1-3 |
| | INTERNATIONAL JOURNAL OF ELECTRO-NICS, vol. 34, no. 3, 1973, pages 319-351<br>Londres, G.B.<br>J.H. COLLINS: "Propagating magnetic waves in thick films. A complementary technology to surface wave acoustics"<br><br>* Figures 4,9,10; page 319, ligne 1 - page 320, ligne 16; page 322, lignes 7-43; page 327, ligne 1 - page 338, ligne 39; page 345, ligne 13 - page 347, ligne 23 * | 1-3 |
| | ELECTRONICS AND COMMUNICATIONS IN JAPAN, vol. 56-B, no. 11, novembre 1973, pages 103-111<br>Washington, U.S.A.<br>M. TSUTSUMI: "Magnetostatic and magnetoelastic surface waves propagating through a ferrite covered with a slow-wave circuit"<br><br>* En entier * | 1-3 |

**CLASSEMENT DE LA DEMANDE (Int. Cl. 3)**

H 03 H 2/00

**DOMAINES TECHNIQUES RECHERCHES (Int. Cl. 3)**

H 03 H
H 01 P
G 11 C
G 10 K

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

./.

Le présent rapport de recherche a été établi pour toutes les revendications

| Lieu de la recherche | Date d'achèvement de la recherche | Examinateur |
|---|---|---|
| La Haye | 08-10-1980 | DECONINCK |

Office européen
des brevets

**RAPPORT DE RECHERCHE EUROPEENNE**

| DOCUMENTS CONSIDERES COMME PERTINENTS | | | CLASSEMENT DE LA DEMANDE (Int. Cl. ³) |
|---|---|---|---|
| Catégorie | Citation du document avec indication, en cas de besoin, des parties pertinentes | Revendica-tion concernée | |
| | 1977 IEEE MTT-S INTERNATIONAL MI-CROWAVE SYMPOSIUM DIGEST (San Diego, California, US, 21-23 juillet 1977) pages 332-335 New York, U.S.A. J. COLLINS: "Microwave devices based on magnetostatic wave reflecting arrays" <br> * En entier * | 1-3,21 | |
| A | FR - A - 2 135 303 (UNITED KINGDOM) <br> * En entier * | 1-3,10-22 | |
| A | GB - A - 1 386 243 (GENERAL ELECTRIC) <br> * En entier * | 1 | |

**DOMAINES TECHNIQUES RECHERCHES (Int. Cl. ³)**

OEB Form 1503.2   06.78